(19) Europäisches Patentamt
European Patent Office
Office européen des brevets

(11) **EP 4 756 785 A1**

(12) **EUROPEAN PATENT APPLICATION**
published in accordance with Art. 153(4) EPC

(43) Date of publication:
**10.06.2026 Bulletin 2026/24**

(21) Application number: **24849004.7**

(22) Date of filing: **23.07.2024**

(51) International Patent Classification (IPC):
**G09F 9/00** (2006.01)    **B60K 35/00** (2024.01)
**C03C 21/00** (2006.01)

(52) Cooperative Patent Classification (CPC):
**B60K 35/00; C03C 21/00; G09F 9/00**

(86) International application number:
**PCT/JP2024/026361**

(87) International publication number:
**WO 2025/028349 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.07.2023 JP 2023123718**

(71) Applicant: **AGC INC.**
**Chiyoda-ku,**
**Tokyo 1008405 (JP)**

(72) Inventors:
• **HOKARI, Ryou**
**Tokyo 100-8405 (JP)**
• **INOUE, Atsushi**
**Tokyo 100-8405 (JP)**
• **WATANABE, Toshinari**
**Tokyo 100-8405 (JP)**

(74) Representative: **Müller-Boré & Partner**
**Patentanwälte PartG mbB**
**Friedenheimer Brücke 21**
**80639 München (DE)**

(54) **DISPLAY DEVICE**

(57) The present invention suppresses cracking of a cover member. This display device 1 includes: a bottom member 5; a display panel 3 provided on the bottom member 5; side wall members 8b and 8c provided around the display panel 3; and a glass cover member 2 provided on the display panel 3 and the side wall members 8b and 8c and having a thickness tcg of 0.3-0.7 mm. When the orientation from the bottom member 5 toward the cover member 2 is defined as a first orientation in the thickness direction of the cover member 2, the cover member 2 has a first main surface 2A on the first orientation side, a second main surface 2B on the opposite side to the first main surface 2A, and an end surface 2C connecting the first main surface 2A and the second main surface 2B. When a parameter A is a value represented by formula (1), a parameter B is a value represented by formula (2), a parameter C is a value represented by formula (3), a parameter D is a value represented by formula (4), and a parameter T is a value represented by formula (5), the parameter T is less than 0.

FIG. 5

EP 4 756 785 A1

## Description

### TECHNICAL FIELD

The present invention relates to a display device.

### BACKGROUND ART

A liquid crystal display or an organic EL display may be used in an in-vehicle display device or the like that displays information or the like necessary for driving. In such a display device, a glass cover member may be disposed to protect a front surface. For example, Patent Literature 1 discloses an in-vehicle display device capable of improving the impact resistance of the cover member.

### CITATION LIST

### PATENT LITERATURE

Patent Literature 1: WO2016/027812

### SUMMARY OF INVENTION

### TECHNICAL PROBLEM

For example, in an in-vehicle display device or the like, the cover member is required to have excellent impact resistance such that the cover member does not break even if the head of an occupant or the like hits the cover member when a vehicle collision accident occurs.
An object of the present invention is to provide a display device capable of suppressing cracking of the cover member.

### SOLUTION TO PROBLEM

The display device according to the present disclosure is a display device including:

a bottom member;
a display layer provided on or above the bottom member;
a side wall member provided around the display layer; and
a cover member including a glass, provided on or above the display layer and the side wall member, and having a thickness of 0.3 mm or more and 0.7 mm or less, in which
when a direction from the bottom member toward the cover member in a thickness direction of the cover member is defined as a first direction, the cover member has a first main surface on a first direction side, a second main surface opposite to the first main surface, and an end surface connecting the first main surface and the second main surface, and
a parameter T is less than 0,
provided that a parameter A, a parameter B, a parameter C, a parameter D, and the parameter T are represented by the following Formula (1) to Formula (5).

$$A = Ecg \times tcg^2 \qquad (1)$$

$$B = \Sigma(Eb \times tb^2) \qquad (2)$$

$$C = \Sigma(Eb \times tc) \qquad (3)$$

$$D = Ed \times td^2 \qquad (4)$$

$$T = 0.212245 + A(-0.00997 + 0.000124 \times B + 0.0000362 \times C - 0.000022 \times D - 0.00809 \times G) - 0.00817 \times B - 0.00183 \times C + 0.001722 \times D + 0.957752 \times G \tag{5}$$

Ecg is a Young's modulus (GPa) of the cover member,

tcg is the thickness (mm) of the cover member,

Eb is a Young's modulus (GPa) of the side wall member,

tb is a thickness (mm) of a portion of the side wall member protruding outward from the end surface of the cover member,

tc is a protrusion length (mm) of the portion of the side wall member protruding outward from the end surface of the cover member,

Ed is a Young's modulus (GPa) of the bottom member,

td is a thickness (mm) of the bottom member, and

G is a protrusion length (mm) of the first main surface of the cover member in the first direction from a surface of a frame member on the first direction side, the frame member being adjacent to an outer side of the end surface of the cover member.

ADVANTAGEOUS EFFECTS OF INVENTION

According to the present invention, cracking of the cover member can be suppressed.

BRIEF DESCRIPTION OF DRAWINGS

FIG. 1 is a schematic diagram illustrating a display device according to the present embodiment.

FIG. 2 is a cross-sectional view taken along line A-A in FIG. 1.

FIG. 3 is a cross-sectional view taken along line B-B in FIG. 1.

FIG. 4 is a bottom view of a bottom member.

FIG. 5 is a partially enlarged cross-sectional view of the display device according to the present embodiment.

FIG. 6 is a schematic partially enlarged view of a bottom member provided with a rib.

DESCRIPTION OF EMBODIMENTS

The display device according to the present disclosure is a display device including: a bottom member; a display layer provided on or above the bottom member; a side wall member provided around the display layer; and a glass cover member provided on or above the display layer and the side wall member and having a thickness of 0.3 mm or more and 0.7 mm or less, in which when a direction from the bottom member toward the cover member in a thickness direction of the cover member is defined as a first direction, the cover member has a first main surface on the first direction side, a second main surface opposite to the first main surface, and an end surface connecting the first main surface and the second main surface, and when a parameter A is set to a value represented by the above Formula (1), a parameter B is set to a value represented by the above Formula (2), a parameter C is set to a value represented by the above Formula (3), a parameter D is set to a value represented by the above Formula (4), and a parameter T is set to a value represented by the above Formula (5), the parameter T is less than 0.

A preferred embodiment of the present invention will be described below in detail with reference to the accompanying drawings. The present invention is not limited to the embodiment and also includes a combination of embodiments when there are a plurality of embodiments. In addition, rounding ranges are included for numerical values.

(1. Configuration of Display Device)

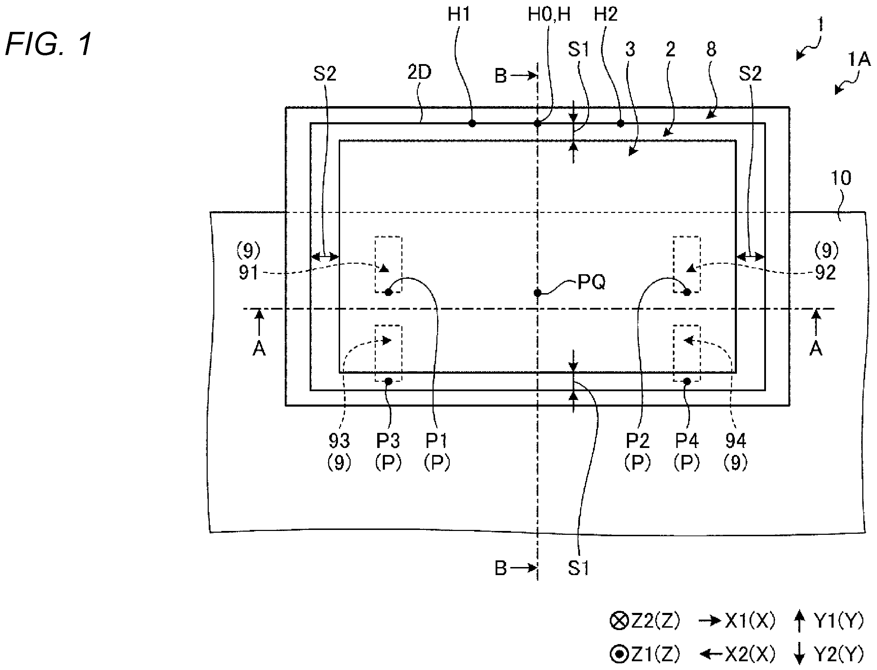

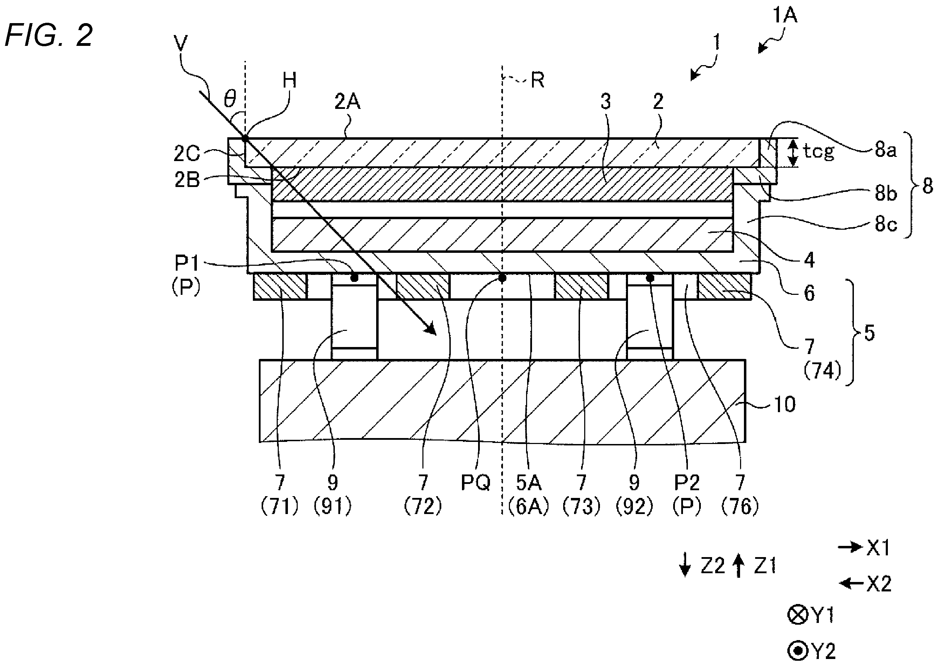

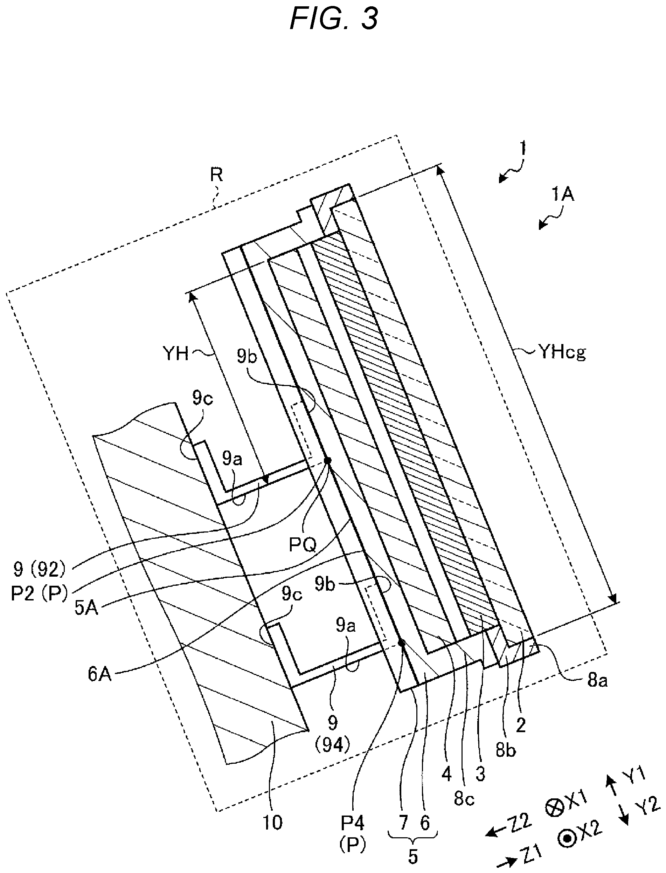

FIG. 1 is a schematic diagram illustrating a display device according to the present embodiment, FIG. 2 is a cross-sectional view taken along line A-A in FIG. 1, and FIG. 3 is a cross-sectional view taken along line B-B in FIG. 1. As illustrated in FIG. 1, a display device 1 according to the present embodiment is an in-vehicle display device to be provided in a vehicle. The display device 1 is, for example, a car navigation device. The display device 1 can be used for any purpose and may be another display device mounted on a vehicle, such as a display audio device. As will be described in detail later, the display device 1 is fixed to an interior portion 10 of a vehicle via a fixing point P formed on a back surface opposite to a display surface. The interior portion 10 is a member provided inside a vehicle, and is, for example, a part of a dashboard of the vehicle. The display device 1 of the present embodiment is particularly suitable for use as a display device provided in front of a front row of a vehicle, that is, in the case of a passenger car, on a dashboard in front of the driver's seat or passenger seat. However, the display device 1 can be used for any purpose, and may not be provided in a vehicle.

Hereinafter, a thickness direction of the display device 1 is defined as a Z direction, and when the display device 1 is attached to a vehicle, a direction (left-right direction in the example of FIG. 1) orthogonal to the Z direction and along a horizontal surface is defined as an X direction, and a direction (up-down direction in the example of FIG. 1) orthogonal to the Z direction and the X direction is defined as a Y direction. In addition, one direction along the X direction (right direction in the example of FIG. 1) is defined as a direction X1, and the other direction along the X direction (left direction in the example of FIG. 1) is defined as a direction X2. One direction along the Y direction (direction toward an upper side in a vertical direction) is defined as a direction Y1, and the other direction along the Y direction (direction toward a lower side in the vertical direction) is defined as a direction Y2. One direction along the Z direction (direction from back surface to display surface of display device 1) is defined as a direction Z1 (first direction), and the other direction along the Z direction (direction from display surface to back surface of display device 1) is defined as a direction Z2. In the present embodiment, an end portion of the display device 1 on the direction Y1 side is an end portion positioned on the upper side in the vertical direction (upper end portion).

As illustrated in FIG. 2, the display device 1 includes a cover member 2, a display panel 3 as a display layer, a backlight unit 4, a bottom member 5, and a surrounding member 8. In the display device 1, the bottom member 5, the backlight unit 4, the display panel 3, and the cover member 2 are disposed (overlapped) in this order in the direction Z1, and the surrounding member 8 having a frame shape is disposed around the cover member 2, the display panel 3, and the backlight unit 4. That is, the cover member 2, the bottom member 5, and the surrounding member 8 constitute a housing 1A that houses the display panel 3. The bottom member 5 covers back surfaces (surfaces opposite to surfaces on a display side) of the cover member 2 and the display panel 3, and the surrounding member 8 covers side surfaces of the cover member 2 and the display panel 3.

(Cover Member)

The cover member 2 is a transparent sheet-shaped member that transmits visible light. The cover member 2 is provided on the display panel 3 and a side wall member to be described later (on the direction Z1 side of the display panel 3 and the side wall member). The cover member 2 has a first main surface 2A which is a main surface on the direction Z1 side (display surface side), a second main surface 2B which is a main surface on the direction Z2 side (back surface side), and an end surface 2C connecting the first main surface 2A and the second main surface 2B. The end surface 2C is also referred to as a side surface of the cover member 2. In the cover member 2, it is preferable that the second main surface 2B is a surface on the display panel 3 side and the first main surface 2A is a surface opposite to the display panel 3 and exposed to the outside. A printed layer may be provided on the second main surface 2B side (on the second main surface 2B) of the cover member 2. The printed layer is a layer that shields the cover member 2 from light and has a lower transmittance to visible light than the cover member 2. Examples of the printed layer include a black layer with low transmittance of visible light and a layer with a pattern such as wood grain. The printed layer is preferably provided so as to surround a region of the second main surface 2B that overlaps the display panel 3 when viewed from the Z direction. Further, the cover member 2 may be provided with a functional layer including at least one of an anti-glare layer, an anti-reflection layer, and an antifouling layer on the first main surface 2A side.

A thickness tcg of the cover member 2 is 0.3 mm or more and 0.7 mm or less, preferably 0.4 mm or more and 0.7 mm or less, preferably 0.4 mm or more and 0.55 mm or less, and more preferably 0.4 mm or more and less than 0.5 mm. The thickness tcg is a length from the first main surface 2A to the second main surface 2B in the Z direction.

In the example of the present embodiment, the cover member 2 has a flat sheet shape that is rectangular when viewed from the Z direction. As for a size of the cover member 2, for example, when the cover member 2 is rectangular, a length in a longitudinal direction (X direction in the example of the present embodiment) is 50 mm or more and 1500 mm or less, preferably 100 mm or more and 1200 mm or less, and a length in a lateral direction (Y direction in the example of the present embodiment) is 40 mm or more and 500 mm or less, preferably 100 mm or more and 300 mm or less. However, the cover member 2 is not limited to a flat sheet shape that is rectangular when viewed from the Z direction, and may have any shape. The cover member 2 may have, for example, an elliptical shape when viewed from the Z direction, or may have, for example, a curved shape. In addition, the cover member 2 may have any size. When the cover member 2 has a curved shape, a thickness direction of the cover member 2 at a center position of a main surface of the cover member 2 may be defined as the Z direction.

The Young's modulus Ecg of the cover member 2 is preferably 60 GPa or more and 90 GPa or less, more preferably 70 GPa or more and 80 GPa or less, and still more preferably 70 GPa or more and 75 GPa or less. The Young's modulus of the members including the cover member 2 may be obtained by a tensile test (JIS K7161-1, 2: 2014, JIS K7113: 1995).

In the present embodiment, the cover member 2 is made of glass. The cover member 2 is preferably made of strengthened glass, and the strengthened glass is preferably chemically strengthened glass.

When the cover member 2 is made of chemically strengthened glass, a thickness (DOL) of a compressive stress layer of the cover member 2 is, for example, preferably 10 $\mu$m or more, more preferably 10 $\mu$m or more and 180 $\mu$m or less, still more preferably 15 $\mu$m or more and 50 $\mu$m or less, even more preferably 25 $\mu$m or more and 50 $\mu$m or less, and yet still more preferably 30 $\mu$m or more and 50 $\mu$m or less.

A surface compressive stress (CS) of the compressive stress layer is preferably 500 MPa or more, more preferably 650 MPa or more, and still more preferably 750 MPa or more. Although an upper limit is not particularly limited, for example, CS is preferably 1200 MPa or less.

Examples of a method for subjecting glass to a chemical strengthening treatment to obtain chemically strengthened glass include, typically, a method of immersing glass in a $KNO_3$ molten salt to conduct an ion exchange treatment, followed by cooling the glass to around room temperature. Treatment conditions such as the temperature of the $KNO_3$ molten salt and the immersion time may be set such that the surface compressive stress and the thickness of the compressive stress layer have desired values.

Examples of a glass type include soda-lime glass and aluminosilicate glass ($SiO_2$-$Al_2O_3$-$Na_2O$-based glass). Among them, aluminosilicate glass is preferred from the viewpoint of strength.

Examples of a glass material include a glass material containing, in terms of mol% based on oxides, 50% or more and 80% or less of $SiO_2$, 1% or more and 20% or less of $Al_2O_3$, 6% or more and 20% or less of $Na_2O$, 0% or more and 11% or less of $K_2O$, 0% or more and 15% or less of MgO, 0% or more and 6% or less of CaO, and 0% or more and 5% or less of $ZrO_2$.

Glass for chemical strengthening, which is based on an aluminosilicate glass, (for example, "Dragontrail (registered trademark)" manufactured by AGC Inc.) can also be suitably used.

More specifically, examples of a more preferable composition of the glass for the cover member 2 include the following glass compositions. For example, "containing 0% to 25% of MgO" means that MgO is not essential but may be contained up to 25%. The glass of (i) below is categorized in soda-lime silicate glass, the glass of (ii) and (iii) below are categorized in aluminosilicate glass, and the glass of (iv) to (vi) below are categorized in lithium aluminosilicate glass.

(i) Glass having a composition containing, in terms of mol% based on oxides, 63% to 73% of $SiO_2$, 0.1% to 5.2% of $Al_2O_3$, 10% to 16% of $Na_2O$, 0% to 1.5% of $K_2O$, 0% to 5.0% of $Li_2O$, 5% to 18% of MgO, and 1% to 10% of CaO.
(ii) Glass having a composition containing, in terms of mol% based on oxides, 50% to 74% of $SiO_2$, 5% to 15% of $Al_2O_3$, 10% to 20% of $Na_2O$, 0% to 8% of $K_2O$, 0% to 5.0% of $Li_2O$, 2% to 15% of MgO, 0% to 6% of CaO, and 0% to 5% of $ZrO_2$, in which a total content of $SiO_2$ and $Al_2O_3$ is 65% to 85%, a total content of $Na_2O$ and $K_2O$ is 12% to 25%, and a total content of MgO and CaO is 1% to 15%.
(iii) Glass having a composition containing, in terms of mol% based on oxides, 68% to 80% of $SiO_2$, 4% to 10% of $Al_2O_3$, 5% to 15% of $Na_2O$, 0% to 1% of $K_2O$, 0% to 5.0% of $Li_2O$, 4% to 15% of MgO, and 0% to 1% of $ZrO_2$.
(iv) Glass having a composition containing, in terms of mol% based on oxides, 67% to 75% of $SiO_2$, 0% to 4% of $Al_2O_3$, 7% to 15% of $Na_2O$, 1% to 9% of $K_2O$, 0% to 5.0% of $Li_2O$, 6% to 14% of MgO, and 0% to 1.5% of $ZrO_2$, in which a total content of $SiO_2$ and $Al_2O_3$ is 71% to 75%, a total content of $Na_2O$ and $K_2O$ is 12% to 20%, and a content of CaO is less than 1% when CaO is contained.
(v) Glass having a composition containing, in terms of mol% based on oxides, 50% to 73% of $SiO_2$, 5% to 20% of $Al_2O_3$, 0% to 6% of $B_2O_3$, 0% to 10% of $P_2O_5$, 4% to 12% of $Li_2O$, 3% to 20% of $Na_2O$, 0% to 5% of $K_2O$, 0% to 8% of MgO, 0% to 2% of CaO, 0% to 5% of SrO, 0% to 5% of BaO, 0% to 5% of ZnO, 0% to 2% of $TiO_2$, and 0% to 4% of $ZrO_2$.
(vi) Glass having a composition containing, in terms of mol% based on oxides, 58% to 80% of $SiO_2$, 13% to 18% of $Al_2O_3$, 0% to 5% of $B_2O_3$, 0.5% to 4% of $P_2O_5$, 3% to 10% of $Li_2O$, 5% to 20% of $Na_2O$, 0% to 2% of $K_2O$, 0% to 11% of MgO, 0% to 20% of CaO, 0% to 20% of SrO, 0% to 15% of BaO, 0% to 10% of ZnO, 0% to 1% of $TiO_2$, and 0% to 2% of $ZrO_2$.

(Display Panel)

The display panel 3 is a panel that displays an image, and is provided on the bottom member 5 (on the direction Z1 side of the bottom member). Further, the display panel 3 is disposed on the direction Z2 side of the cover member 2 so as to overlap the cover member 2. In the display panel 3, a display surface which is a surface on the direction Z1 side is adhered to the second main surface 2B of the cover member 2 by an adhesive layer (not illustrated). The adhesive layer is, for example, an optical clear adhesive (OCA) film or an OCA tape, and a thickness (length in the Z direction) thereof is, for example, 5 $\mu$m or more and 400 $\mu$m or less, and preferably 50 $\mu$m or more and 200 $\mu$m or less.

The display panel 3 is a liquid crystal panel, an organic EL panel, a flexible organic EL panel, a plasma display panel (PDP), an electronic ink panel, or the like, and may include a touch panel or the like. When the display panel 3 includes a glass substrate, the glass substrate is the thickest part and dominates rigidity of the entire display panel. Therefore, the Young's modulus of the glass substrate may be regarded as the Young's modulus of the display panel 3.

The Young's modulus of the display panel 3 is preferably 1.5 GPa or more, more preferably 60 GPa or more, and still more preferably 70 GPa or more. The Young's modulus of the display panel 3 is preferably 90 GPa or less, and more preferably 75 GPa or less. Upper and lower limit values of the numerical ranges may be appropriately combined, that is, the Young's modulus of the display panel 3 is preferably 1.5 GPa or more and 90 GPa or less, more preferably 60 GPa or more and 75 GPa or less, and still more preferably 70 GPa or more and 75 GPa or less.

That is, a thickness of the display panel 3 is preferably 0.05 mm or more and 2.0 mm or less, more preferably 1.0 mm or more and 1.3 mm or less, and still more preferably 1.1 mm or more and 1.3 mm or less. The thickness of the display panel 3 is a length in the Z direction from a main surface on the direction Z1 side to a main surface on the direction Z2 side of the display panel 3.

As illustrated in FIG. 1, when viewed from the Z direction, a distance from an end portion of the cover member 2 on the direction Y1 side to an end portion of the display panel 3 on the direction Y1 side is defined as a distance S1. From the viewpoint of adhering and holding the cover member 2 with sufficient adhesive strength, the distance S1 is preferably 2 mm or more and 30 mm or less, and more preferably 5 mm or more and 20 mm or less. The numerical range of the distance S1 can also be applied to a distance from an end portion of the cover member 2 on the direction Y2 side to an end portion of the display panel 3 on the direction Y2 side.

As illustrated in FIG. 1, when viewed from the Z direction, a distance from an end portion of the cover member 2 on the direction X1 side to an end portion of the display panel 3 on the direction X1 side is defined as a distance S2. From the viewpoint of adhesive strength and design, the distance S2 is preferably 2 mm or more and 200 mm or less, and more preferably 5 mm or more and 150 mm or less. The numerical range of the distance S2 can also be applied to a distance from an end portion of the cover member 2 on the direction X2 side to an end portion of the display panel 3 on the direction X2 side.

(Backlight Unit)

The backlight unit 4 is a light source that irradiates the display panel 3 with light for image display, and is disposed on the direction Z2 side of the display panel 3 to overlap the display panel 3.

The backlight unit 4 generally includes members such as a lens sheet, a diffusion sheet, a light guide plate, a lamp, and a reflector. Among these members, usually, the light guide plate is the thickest part and dominates rigidity of the entire backlight unit 4. Therefore, the Young's modulus of the light guide plate may be regarded as the Young's modulus of the backlight unit 4.

The Young's modulus of the backlight unit 4 is preferably 1 GPa or more and 90 GPa or less, more preferably 2 GPa or more and 85 GPa or less, and still more preferably 60 GPa or more and 85 GPa or less.

A thickness of the backlight unit 4 is preferably 1 mm or more and 10 mm or less, more preferably 2 mm or more and 6 mm or less, and still more preferably 3 mm or more and 5 mm or less. The thickness of the backlight unit 4 is a length in the Z direction from a main surface on the direction Z1 side to a main surface on the direction Z2 side of the backlight unit 4.

The display device 1 may not be provided with the backlight unit 4. In this case, in the display device 1, the cover member 2, the display panel 3, and the bottom member 5 are disposed (overlapped) in this order in the direction Z2. When the backlight unit 4 is not provided, a self-luminous display panel that does not require the backlight unit 4, such as an organic EL panel or a micro LED panel, is selected as the display panel 3.

(Bottom Member)

The bottom member 5 is disposed on the direction Z2 side of the display panel 3 (the backlight unit 4 in the present embodiment) to overlap the display panel 3 (the backlight unit 4 in the present embodiment), and can be said as being a bottom portion of the housing.

The bottom member 5 includes a plate portion 6 and ribs 7. The plate portion 6 is a plate-shaped member disposed to overlap the display panel 3. The ribs 7 are members formed to protrude from a main surface 6A of the plate portion 6 on the direction Z2 side, and have a quadrangular prism shape in the present embodiment. By forming the bottom member 5 into a shape having the ribs 7, the display device 1 can be made lighter in weight as compared with a case where the bottom member 5 is formed into a thick plate shape having no rib 7.

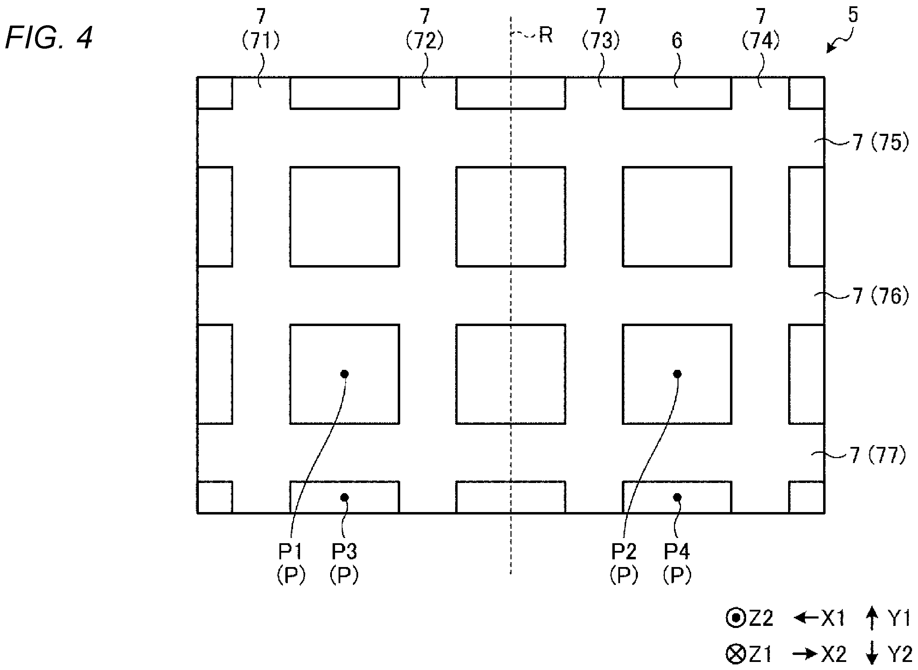

FIG. 4 is a bottom view of a bottom member. As illustrated in FIG. 4, when the bottom member 5 of the present embodiment is viewed from the direction Z2 side toward the direction Z1, a plurality of ribs 7 are provided in a grid shape in the bottom member 5. Specifically, a plurality of ribs 7 (rib 71, rib 72, rib 73, and rib 74) extending in the Y direction in FIG. 4 intersect a plurality of ribs 7 (rib 75, rib 76, and rib 77) extending in the X direction in FIG. 4. However, the shape of the ribs 7 is not limited to FIG. 3 and may be any shape, and may be, for example, a curved shape instead of a linear shape, or may not be provided in a grid shape. The bottom member 5 may not have the ribs 7. In this case, the bottom member 5 includes only the plate portion 6.

In FIG. 3, the fixing point P is formed on a main surface 5A of the bottom member 5 on the direction Z2 side. The fixing point P is a portion of the bottom member 5 serving as an interface to be fixed to a vehicle (to the interior portion 10 in the present embodiment), and is a portion to which a bracket 9, which will be described later, is to be attached in the present embodiment.

The bottom member 5 is fixed to the bracket 9 while the main surface 5A is in contact with a fixing member (here, the bracket 9). When a region of the main surface 5A that comes into contact with the fixing member is defined as a contact region, it can be said that the fixing point P is a point on the contact region. The fixing point P may be any position on the contact region. For example, in FIG. 1, the fixing point P (fixing points P1 to P4) is exemplified as a midpoint position in the X direction of a side positioned on the direction Y2 side among sides of each contact region. As described above, the fixing point P may be the midpoint position in the X direction of the side positioned on the direction Y2 side among the sides of the contact region. It can be said that one fixing point P is formed for each contact region. That is, when there are a plurality of fixing points P, it can be said that a plurality of contact regions are formed at separate positions and one fixing point P is formed in each contact region. When there is one fixing point P, it can be said that there is one contact region.

For example, when the display device 1 (bottom member 5) is fixed to the bracket 9, a position on the main surface 5A overlapping a midpoint of one side of an end of a convex surface 9a of the bracket 9 (that is, a midpoint in the X direction of a side of the contact region on the direction Y2 side) may be set as the fixing point P. When the bottom member 5 is fixed to the bracket 9 with a fixing tool such as a bolt, the fixing point P may be a portion of the main surface 5A where a hole (for example, a bolt hole), into which the fixing tool is inserted, is open, or when the bottom member 5 is fixed to the bracket 9 with a plurality of fixing tools per contact region, the fixing point P may be positioned at a center position among portions where holes (for example, bolt holes), into which the fixing tools are inserted, are open. For example, when the bottom member 5 is fixed to the bracket 9 with an adhesive or the like, the fixing point P may be a point on the contact region of the main surface 5A to which the adhesive is applied. For example, a protrusion may be formed on the main surface 5A of the bottom member 5 and the bottom member 5 may be fixed to a vehicle (the interior portion 10 in the present embodiment) by inserting the protrusion into a recess formed in the vehicle. In this case, the protrusion of the bottom member 5 may be regarded as the bracket 9 without separately providing the bracket 9. In this case, a surface of the protrusion of the bottom member 5 on the direction Z1 side may be the contact region, and a point on the contact region may be the fixing point P. For example, a recess may be formed in the main surface 5A of the bottom member 5 and the bottom member 5 may be fixed to a vehicle (the interior portion 10 in the present embodiment) by inserting a protrusion formed on the vehicle into the recess of the main surface 5A. In this case, the protrusion of the vehicle may be regarded as the bracket 9 without separately providing the bracket 9. In this case, a surface of the recess of the bottom member 5 on the direction Z1 side may be the contact region, and a point on the contact region may be the fixing point P. The position of the fixing point P and the like will be described later.

The Young's modulus Ed of the bottom member 5 is preferably 1.5 GPa or more, more preferably 30 GPa or more, and still more preferably 40 GPa or more. The Young's modulus Ed of the bottom member 5 is preferably 250 GPa or less, more preferably 100 GPa or less, and still more preferably 80 GPa or less.

In the display device according to the present embodiment, the cover member 2 described above is preferably strengthened glass having a compressive stress layer with a thickness of 10 $\mu$m or more, the Young's modulus Ecg of the cover member 2 is preferably 60 GPa or more and 90 GPa or less, and the Young's modulus Ed of the bottom member 5 is preferably 40 GPa or more and 250 GPa or less.

As a material of the bottom member 5, for example, a metal (simple substance) or an alloy containing a metal element such as aluminum or magnesium is preferred. The material of the bottom member 5 may be resin or a laminate of a resin layer and a metal layer.

Although the bottom member 5 is disposed most on the direction Z1 side among the members of the display device 1 in the example of the present embodiment, the present invention is not limited thereto, and for example, another member may be provided further on the direction Z1 side than the bottom member 5. That is, even in the case where there is another member further disposed on the direction Z1 side than the bottom member 5, a layer (bottom member 5) on which the fixing point P is formed is treated as the bottom member in the present embodiment. In other words, the layer on which the fixing point P is formed and which is disposed most in the direction Z1 is treated as the bottom member 5.

(Surrounding Member)

The surrounding member 8 is a frame-shaped member that is provided to surround the cover member 2, the display panel 3, and the backlight unit 4 when viewed from the Z direction, and can be said as being a side wall portion of the housing.

The surrounding member 8 includes a frame member and a side wall member.

The frame member is a frame-shaped portion surrounding the cover member 2, and is a portion of the surrounding member 8 positioned further on the direction Z1 side than the second main surface 2B of the cover member 2. That is, the frame member is adjacent to an outer side of the end surface 2C of the cover member 2. The outer side here refers to a radially outer side when a central axis of the cover member 2 along the Z direction is set as an axial direction, and the same applies to the following description. The central axis of the cover member 2 is an axis that passes through a center point of the cover member 2 when viewed from the Z direction and extends in the Z direction.

On the other hand, the side wall member is a portion (a portion provided around the display panel 3) surrounding the display panel 3 (and the backlight unit 4), and is a portion of the surrounding member 8 positioned further on the direction Z2 side than the second main surface 2B of the cover member 2.

As illustrated in FIG. 2, in the example of the present embodiment, the surrounding member 8 includes a frame member 8a and side wall members 8b and 8c. In the example of the present embodiment, the frame member 8a and the side wall member 8b are an integrated member. The side wall member 8b is connected to an end portion of the frame member 8a on the direction Z2 side, and protrudes toward an inner side from the frame member 8a. The inner side here refers to a radially inner side when the central axis of the cover member 2 along the Z direction is set as the axial direction, and the same applies to the following description. The side wall member 8b supports an outer periphery of the second main surface 2B of the cover member 2 on a surface on the direction Z1 side of a region protruding toward the inner side from the frame member 8a. In the present embodiment, although not illustrated, the side wall member 8b and the cover member 2 are adhered via an adhesive layer.

The side wall member 8c is a frame-shaped member provided on the direction Z2 side of the side wall member 8b, and is disposed to surround the display panel 3 and the backlight unit 4 in the present embodiment. In the present embodiment, a surface of the side wall member 8c on the direction Z1 side is adhered to the side wall member 8b via an adhesive layer.

The shape of the surrounding member 8 (the frame member and the side wall member) is not limited to the above description, and may be any shape. For example, the frame member 8a and the side wall member 8b may be separate members. For example, the side wall member may be constituted by one member, or may be constituted by three or more members.

The Young's modulus of the surrounding member 8 (the frame member and the side wall member) is preferably 1 Pa or more and 250 GPa or less, and more preferably 40 GPa or more and 230 GPa or less. When the side wall member and the frame member are constituted by a plurality of members, it is preferable that the Young's modulus of each member falls within the above range.

As a material of the surrounding member 8 (the frame member and the side wall member), for example, a metal (simple substance) or an alloy containing a metal element such as aluminum or magnesium is preferred. The material of the surrounding member 8 (the frame member and the side wall member) may be resin or a laminate of a resin layer and a metal layer. When the surrounding member 8 (the frame member and the side wall member) is constituted by a plurality of members, each member may be made of a different material. For example, in the structure illustrated in FIG. 2, the frame member 8a and the side wall member 8b may be made of resin, and the side wall member 8c may be made of metal.

In the present embodiment, the surrounding member 8 and the bottom member 5 may be separate members or may be an integrated member. For example, among the plurality of members constituting the surrounding member 8, a part of the members may be integrated with the bottom member 5, and some other members may be separated from the bottom member 5. FIG. 2 illustrates a configuration in which the side wall member 8c is integrated with the bottom member 5, and the frame member 8a and the side wall member 8b are separate from the bottom member 5.

(2. Fixed State of Display Device)

Next, a state in which the display device 1 is fixed to the interior portion 10 of a vehicle will be described. Hereinafter, fixing of the display device 1 will be described.

(Fixing Point)

As described above, the fixing point P to be fixed to the interior portion 10 is formed on the main surface 5A of the bottom member 5 of the display device 1 on the direction Z2 side. In the present embodiment, a plurality of fixing points P are provided, and in the example of FIG. 1, four fixing points P1, P2, P3, and P4 are provided. The fixing points P1 and P2 are disposed in the X direction (a width direction of a vehicle when the display device 1 is attached to the vehicle). The fixing points P3 and P4 are positioned on the direction Y2 side with respect to the fixing points P1 and P2 (on the lower side in the vertical direction when the display device 1 is attached to a vehicle), and are disposed in the X direction. A line passing through the fixing points P1 and P2 and a line passing through the fixing points P3 and P4 are parallel to each other, and the fixing points P1 to P4 form four vertices of a rectangle.

As illustrated in FIG. 1 to FIG. 3, the bracket 9 as a fixing member may be attached to the fixing point P. In this case, the bottom member 5 is fixed to the interior portion 10 via the bracket 9. In the example of the present embodiment, a bracket 91 is attached to the fixing point P1, a bracket 92 is attached to the fixing point P2, a bracket 93 is attached to the fixing point P3, and a bracket 94 is attached to the fixing point P4.

As illustrated in FIG. 3, the bracket 9 is a long plate-shaped member and is bent in a U-shape. A center of the bracket 9 in a plate width direction is positioned at the fixing point P. In the bracket 9, one side of the end of the convex surface 9a (a surface on the direction Y2 side in FIG. 3) formed by being bent in a U-shape is in contact with the fixing point P. A direction perpendicular to the convex surface 9a of the bracket 9 intersects perpendicularly with the X direction (the width direction of the vehicle). In the bracket 9, one surface 9b connected to the convex surface 9a is in contact with the bottom member 5, and the other surface 9c connected to the convex surface 9a is in contact with the interior portion 10. That is, the position on the main surface 5A of the bottom member 5 overlapping the midpoint of the one side of the end of the convex surface 9a of the bracket 9 (that is, the midpoint in the X direction of the side of the contact region on the direction Y2 side) is the fixing point P. The bracket 9 is fixed to the bottom member 5 and the interior portion 10 with, for example, a screw (not illustrated). The shape of the bracket 9 is not limited to that described above, and may be bent in an S-shape, for example.

Since the display device 1 is attached to a vehicle via the bracket 9 as described above, it can be said that the display device 1 and the bracket 9 constitute a display device unit.

The bottom member 5 may be fixed to the interior portion 10 by, for example, deforming a part of the bottom member 5 without using the bracket 9. Alternatively, a part of the interior portion 10 may be deformed and fixed to the bottom member 5. In this case, each fixing point P may be defined as a center of each fixing portion.

The positions and the number of the fixing points P are not limited to those described above. A plurality of fixing points P may be formed in any number, and each fixing point P in this case may be at any position.

(Intermediate Point PQ)

In the following, an intermediate point PQ is defined to explain the position of the fixing point P in the Y direction with respect to the display device 1 ($YH/YH_{cg}$ which will be described later). The intermediate point PQ is a midpoint between the fixing point P1 and the fixing point P2. When a distance between the intermediate point PQ and the fixing point P1 (or a distance between the intermediate point PQ and the fixing point P2) is defined as a distance X, the distance X is preferably 30 mm or more and 200 mm or less, and more preferably 50 mm or more and 130 mm or less, from the viewpoint of vibration characteristics (JIS D 1601: 1995 vibration test method for automobile parts). When a distance between the fixing point P1 and the fixing point P3 disposed in the Y direction (or a distance between the fixing point P2 and the fixing point P4) is defined as a distance Y, the distance Y is preferably 30 mm or more and 200 mm or less, and more preferably 35 mm or more and 125 mm or less for the same reason.

Since the fixing points P have any number and positions as described above, the definition of the intermediate point PQ for each variation of the positions of the fixing points P will be described below.

Among the fixing points P provided on the bottom member 5, two fixing points P are selected from the direction Y1 side (the upper side in the vertical direction), and a midpoint between the two selected fixing points P is set as an intermediate point PQ. For example, FIG. 1 to FIG. 3 illustrate an example in which the bottom member 5 is fixed to the interior portion 10 at four fixing points P (fixing points P1 to P4) disposed two by two in the Y direction. As illustrated in FIG. 1 to FIG. 3, when there are a plurality of fixing points P in the Y direction, two fixing points most on the direction Y1 side (the fixing point P1 and the fixing point P2 in FIG. 1) are used as the fixing points P for defining the intermediate point PQ (and a virtual plane R which will be described later).

When there are three or more fixing points P at the same position in the Y direction (the same height), two fixing points P having the smallest interval therebetween are selected, and a midpoint therebetween is set as the intermediate point PQ. When there are three or more fixing points equally spaced at the same position in the Y direction, a midpoint between any two fixing points P may be set as the intermediate point PQ. That is, when there are a plurality of candidates for the intermediate point PQ (and the virtual plane R which will be described later), any one of the candidates may satisfy the requirements of the present embodiment.

The bottom member 5 may be fixed to the interior portion 10 at three fixing points P. For example, when explaining by referring to FIG. 1, it can be assumed a case where the fixing point P1 and the fixing point P2 are not present and, instead, another fixing point P' (not illustrated in FIG. 1 and the like) is present on a line connecting the fixing point P1 and the fixing point P2. In this case, the bottom member 5 is fixed to the interior portion 10 at three points of the fixing point P3, the fixing point P4, and the fixing point P'. At this time, when there is no difference in position in the Y direction (height) between the fixing point P3 and the fixing point P4, the fixing point closer to the fixing point P' is selected, and a midpoint between the selected fixing point and the fixing point P' is set as the intermediate point PQ. When there is no difference in distance from the fixing point P', either the fixing point P3 or the fixing point P4 is selected, and a midpoint between the selected fixing point and the fixing point P' is set as the intermediate point PQ. When the fixing point P3 and the fixing point P4 are positioned at different positions in the Y direction, two fixing points P (the fixing point P' and the fixing point on the direction Y1 side among the fixing point P3 and the fixing point P4) are selected from the direction Y1 side, and a midpoint between the selected fixing points is set as the intermediate point PQ, similarly to the definition in the case of having four fixing points P.

(YH/YH$_{cg}$)

As illustrated in FIG. 3, a plane that passes through the intermediate point PQ and is perpendicular to the line connecting the fixing point P1 and the fixing point P2 (two fixing points P used to define the intermediate point PQ) is defined as the virtual plane R. As illustrated in FIG. 3, a length of an intersection line between the cover member 2 and the virtual plane R is defined as a distance YH$_{cg}$. In addition, as illustrated in FIG. 3, a length of an intersection line between the main surface of the display panel 3 and the virtual plane R from the upper end of the display panel 3 (the end portion on the direction Y1 side) to a point corresponding to the intermediate point PQ is defined as a distance YH. The "point corresponding to the intermediate point PQ" is a point where the intermediate point PQ is moved in the thickness direction (Z direction) of the display device 1 and is positioned on the main surface of the display panel 3.

In the display device 1, the position of the fixing point P is preferably set so that the ratio YH/YH$_{cg}$ of the distance YH to the distance YH$_{cg}$ is 0.5 or less. That is, it can be said that the display device 1 is preferably a display device of an "in-dash type or on-dash type (hereinafter, also simply referred to as "in-dash type")" in which the vicinity of the upper end is also fixed to the interior portion 10. In the display device 1, the ratio YH/YH$_{cg}$ is more preferably 0.1 or more and 0.5 or less, and still more preferably 0.3 or more and 0.5 or less.

When the ratio YH/YH$_{cg}$ is greater than 0.5, it can be said that the display device 1 corresponds to a "standing type" in which only a lower end of the bottom member is fixed to the dashboard.

That is, it is preferable that the bottom member 5 according to the present embodiment includes the plate portion 6 and the rib 7 protruding from the main surface of the plate portion 6 on the side opposite to the first direction (the direction Z2 side), at least two fixing points P to be fixed to a vehicle are formed on the main surface on the side opposite to the first direction (the direction Z2 side), and when a virtual plane passing through an intermediate point PQ of two fixing points P and perpendicular to a line connecting the two fixing points P is defined as a virtual plane R, a length of an intersection line between the main surface of the cover member 2 and the virtual plane R is defined as a distance YH$_{cg}$, and a length from an upper end to a point corresponding to the intermediate point PQ in an intersection line between the main surface of the display layer (the display panel 3) and the virtual plane R is defined as a distance YH, the ratio YH/YH$_{cg}$ of the distance YH to the distance YH$_{cg}$ is 0.5 or less.

The display device 1 is fixed to a vehicle as described above.

(3. Configuration for Reducing Cracking of Cover Member)

The cover member 2 according to the present embodiment has a thickness tcg of 0.3 mm or more and 0.7 mm or less, which is relatively thin. As a result of extensive research, the present inventors have found that the manner in which the cover member 2 having such a thickness deforms when subjected to an impact differs from that of a cover member with a greater thickness. The present inventors have also found that it is possible to suppress cracking of the cover member 2 having such a thickness by setting a parameter T to be described later within an appropriate range.

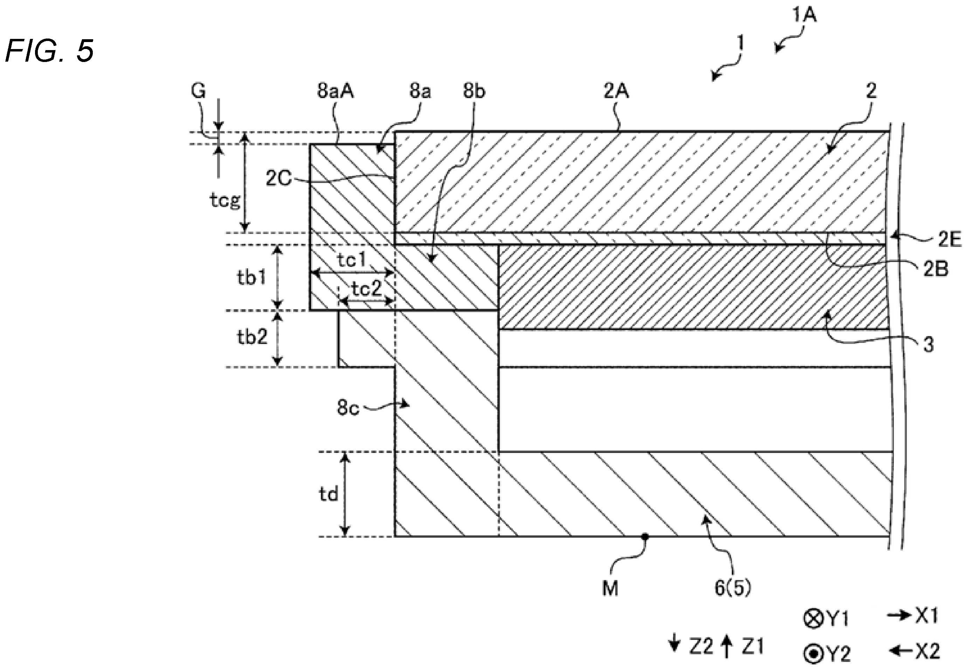

Hereinafter, a configuration for suppressing cracking of the cover member 2 will be described. FIG. 5 is a partially enlarged cross-sectional view of the display device according to the present embodiment. FIG. 5 is a partially enlarged view of a cross section taken along line B-B in FIG. 1. The B-B cross section refers to a cross section perpendicular to the X direction at a position of a reference point H (to be described later) in the X direction.

(Parameter A)

A parameter A for defining the parameter T is set to a value represented by the following Formula (1).

$$A = \mathrm{Ecg} \times \mathrm{tcg}^2 \ (1)$$

In Formula (1), Ecg is the Young's modulus (GPa) of the cover member 2, and tcg is the thickness (mm) of the cover member 2. That is, the parameter A is a parameter indicating the rigidity of the cover member 2.

(Parameter B)

A parameter B for defining the parameter T is set to a value represented by the following Formula (2).

$$B = \Sigma(\mathrm{Eb} \times \mathrm{tb}^2) \ (2)$$

In Formula (2), Eb is the Young's modulus (GPa) of the side wall member. In addition, tb is a thickness (mm) of a portion of the side wall member protruding outward from the end surface 2C of the cover member 2. When the side wall member is made of two or more types of materials, the parameter B is a parameter indicating a total value of the rigidity of each portion (that is, a value obtained by multiplying the "Young's modulus" and the "square of the thickness" of each portion) for each material protruding outward from the end surface 2C of the cover member 2. When the side wall member is made of two or more types of materials and the thickness of the portion protruding outward from the end surface 2C is not uniform for each material, it may be the thickness tb of the side wall member at a point 0.5 mm outward from the end surface 2C.

In the example of FIG. 5, a part of the side wall member 8b and a part of the side wall member 8c protrude outward from the end surface 2C of the cover member 2. Therefore, the parameter B is $(Eb1 \times tb1^2) + (Eb2 \times tb2^2)$, where tb1 is a thickness of the portion of the side wall member 8b protruding outward from the end surface 2C, Eb1 is the Young's modulus of the side wall member 8b, tb2 is a thickness of the portion of the side wall member 8c protruding outward from the end surface 2C, and Eb2 is the Young's modulus of the side wall member 8c.

The value of the parameter B is preferably greater than 0. By setting the value of the parameter B within this range, cracking of the cover member 2 can be suitably suppressed.

(Parameter C)

A parameter C for defining the parameter T is set to a value represented by the following Formula (3).

$$C = \Sigma(Eb \times tc) \ (3)$$

**In** Formula (3), tc is a protrusion length (mm) of the portion of the side wall member protruding outward from the end surface 2C of the cover member 2. When the side wall member is made of two or more types of materials, the parameter C is a parameter indicating a total value of the rigidity of each portion (that is, a value obtained by multiplying the "Young's modulus" and the "protrusion length" of each portion) for each material protruding outward from the end surface 2C of the cover member 2. **In** the example of FIG. 5, a distance in the X direction between an outer surface of the portion of the side wall member protruding from the end surface 2C of the cover member 2 and the end surface 2C can be said to be a protrusion length tc. When the protrusion length of the portion protruding outward from the end surface 2C is not uniform, an average value of the protrusion length at each position may be set as the protrusion length tc.

In the example of FIG. 5, a part of the side wall member 8b and a part of the side wall member 8c protrude outward from the end surface 2C of the cover member 2. Therefore, the parameter C is $(Eb1 \times tc1) + (Eb2 \times tc2)$, where tc1 is a protrusion length of the portion of the side wall member 8b protruding outward from the end surface 2C, Eb1 is the Young's modulus of the side wall member 8b, tc2 is a protrusion length of the portion of the side wall member 8c protruding outward from the end surface 2C, and Eb2 is the Young's modulus of the side wall member 8c.

The protrusion length tc is preferably greater than 0 mm. That is, the display device 1 preferably has a side wall portion that includes a portion protruding outward from the end surface 2C of the cover member 2.

(Parameter D)

A parameter D for defining the parameter T is set to a value represented by the following Formula (4).

$$D = Ed \times td^2 \ (4)$$

In Formula (4), Ed is the Young's modulus (GPa) of the bottom member 5, and td is a thickness (mm) of the bottom member 5. That is, the parameter D is a parameter indicating the rigidity of the bottom member 5. The thickness td of the bottom member 5 here refers to the thickness of the bottom member 5 in a region (overlapping region) overlapping the cover member 2 when viewed from the Z direction, out of the entire region of the bottom member 5.

The parameter D is preferably 50 or more and 700 or less, and more preferably 70 or more and 500 or less. By setting a lower limit of the parameter D to this range, it is possible to appropriately fix the bottom member 5 to a vehicle, and by setting an upper limit of the parameter D to this range, it is possible to absorb an impact and suppress cracking of the cover member 2.

More specifically, in the present embodiment, the thickness td refers to the thickness of the bottom member 5 at a position M in the overlapping region of the bottom member 5, which is 10 mm inward from the position overlapping the end surface of the display panel 3 when viewed from the Z direction. However, for example, when the bottom member 5 at the position M has local unevenness and the thickness is locally increased or decreased (for example, when the thickness at the position M deviates from an average value of the thickness in the overlapping region of the bottom member 5 by 50% or more of the average value), a relatively flat portion within 50 mm around the position M that avoids local unevenness can be set as a position M', and the thickness at the position M' can be used as the thickness td.

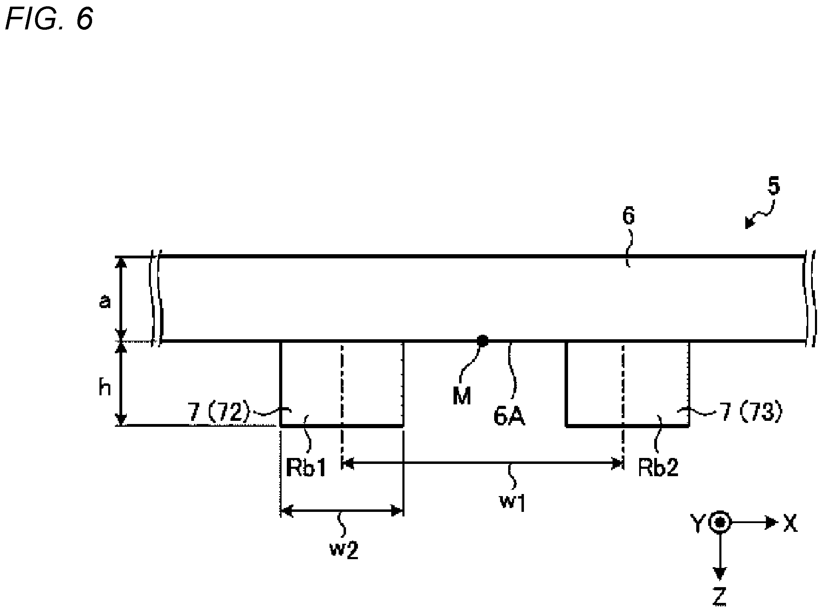

In addition, when the rib 7 is provided on the bottom member 5 within 100 mm around the position M or the position M', the thickness td may be set to a value represented by the following Formula (A). FIG. 6 is a schematic partially enlarged view of the bottom member provided with a rib.
[Math. 1]

$$td = \sqrt[3]{a^3 + \frac{w_2}{w_1}h^3 + 12a\left(b - \frac{a}{2}\right)^2 + 12\frac{w_2}{w_1}h\left(\frac{h}{2} + a - b\right)^2} \quad \cdots \text{Formula (A)}$$

In Formula (A), a is a thickness (mm) of the plate portion 6 of the bottom member 5 in the Z direction as illustrated in FIG. 6, $w_2$ is a width (mm) of a first rib Rb1 as illustrated in FIG. 6, $w_1$ is a distance (mm) between the first rib Rb1 and a second rib Rb2 as illustrated in FIG. 6, and h is a thickness (mm) of the first rib Rb1 and the second rib Rb2 in the Z direction as illustrated in FIG. 6.

The first rib Rb1 is the rib 7 closest to the position M (or the position M') among the ribs 7 of the bottom member 5. The second rib Rb2 is the rib 7 positioned on a line connecting the position M (or the position M') and the first rib Rb1 and closest to the first rib Rb1. In other words, the second rib Rb2 is a rib positioned in an extending direction of a line that passes through the first rib Rb1 and the position M (or the position M') and is perpendicular to a center line of the first rib Rb1.

The width of the first rib Rb1 refers to the width of the first rib Rb1 when viewed from the extending direction of the first rib Rb1. The distance between the first rib Rb1 and the second rib Rb2 refers to a distance between a central axis of the first rib Rb1 and a central axis of the second rib Rb2 when viewed from the extending direction of the first rib Rb1. Further, it can be said that the distance between the first rib Rb1 and the second rib Rb2 is referred to as a distance between the first rib Rb1 (rib 73) and the second rib Rb2 (rib 75) (a distance between the center lines) on a perpendicular line of the first rib Rb1 (rib 73) passing through a point p. When the first rib Rb1 and the second rib Rb2 have different thicknesses in the Z direction, h may be an average value of the thicknesses of the first rib Rb1 and the second rib Rb2 in the Z direction.
In Formula (A), b is represented by the following Formula (B).
[Math. 2]

$$b = \frac{0.5w_1 \cdot a^2 + 0.5w_2 \cdot h^2 + w_2 \cdot a \cdot h}{w_1 \cdot a + w_2 \cdot h} \quad \cdots \text{Formula (B)}$$

The thickness td of the bottom member 5 defined as described above is preferably 0.5 mm or more and 5 mm or less, more preferably 1 mm or more and 4 mm or less, and still more preferably 1 mm or more and 3 mm or less. By setting a lower limit of the thickness td to this range, it is possible to appropriately fix the bottom member 5 to a vehicle, and by setting an upper limit of the thickness td to this range, it is possible to absorb an impact and suppress cracking of the cover member 2.

(Reference Point H)

The reference point H which is a reference position of the B-B cross section will be described.
As illustrated in FIG. 1, on a corner 2D of the cover member 2 on the direction Y1 side (a boundary between the first main surface 2A and the end surface 2C), when viewed from the Z direction, a position where a distance from each of the two fixing points P used to define the intermediate point PQ is equal is defined as an equidistance point H0. In the example of the present embodiment, since the fixing points P1 and P2 are used to define the intermediate point PQ, it can be said that the equidistance point H0 is a point where a distance from the fixing point P1 is equal to a distance from the fixing point P2 on the corner 2D of the cover member 2 in the Y direction, when viewed from the Z direction. That is, in the example of the present embodiment, the distance from the equidistance point H0 to the fixing point P1 when viewed from the Z direction is equal to the distance from the equidistance point H0 to the fixing point P2 when viewed from the Z direction.
In an extending direction (the X direction in the example of FIG. 1) of the corner 2D of the cover member 2 in the Y direction, positions on the corner 2D separated from the equidistance point H0 by a predetermined distance D1 are taken as points H1 and H2. That is, in the example of FIG. 1, the point H1 is a position on the corner 2D separated from the equidistance point H0 by the predetermined distance D1 in the direction X2, and the point H2 is a position on the corner 2D separated from the equidistance point H0 by the predetermined distance D1 in the direction X1. In this case, the reference point H is set as any position between the point H1 and the point H2 on the corner 2D of the cover member 2 in the Y direction. The predetermined distance D1 here may be freely set, and may be, for example, 18 mm.

The reference point H may be any position between the point H1 and the point H2 on the corner 2D in the Y direction, and is preferably a position where the rigidity becomes minimum among positions between the point H1 and the point H2 on the corner 2D in the Y direction. In the example of the present embodiment, since among the positions between the point H1 and the point H2, the position where the rigidity becomes minimum is the equidistance point H0, the equidistance point H0 is treated as the reference point H.

The reference point H is not limited to the position where the rigidity becomes minimum between the point H1 and the point H2. For example, the equidistance point H0 may be treated as the reference point H without considering the rigidity.

The reference point H may be, for example, a position of a hitting point where an impactor collides in a head impact test.

As illustrated in FIG. 2, a virtual line that passes through the reference point H and the bottom member 5 and is inclined at an angle $\theta$ with respect to the Z direction is defined as a virtual line V. That is, it can be said that the virtual line V is a line passing through the reference point H and inclined inward by the angle $\theta$ with respect to the Z direction. In the present embodiment, the angle $\theta$ is 30° or more and 45° or less. It can be said that the virtual line V corresponds to a direction in which a high impact is transmitted when an impact is applied to the corner 2D in the head impact test or the like.

(Parameter T)

Hereinafter, the parameter T will be described. The parameter T is set to a value represented by the following Formula (5).

$$T = 0.212245 + A(-0.00997 + 0.000124 \times B + 0.0000362 \times C - 0.000022 \times D - 0.00809 \times G) - 0.00817 \times B - 0.00183 \times C + 0.001722 \times D + 0.957752 \times G \tag{5}$$

As illustrated in FIG. 5, in Formula (5), G is a protrusion length (mm) of the first main surface 2A of the cover member 2 from a surface 8aA of the frame member 8a on the direction Z1 side toward the direction Z1 side. That is, for example, when the first main surface 2A protrudes from the surface 8aA by 2 mm in the direction Z1, the protrusion length G is +2 mm, and when the surface 8aA protrudes from the first main surface 2A by 2 mm in the direction Z1, the protrusion length G is -2 mm. FIG. 5 illustrates a configuration example in which the first main surface 2A protrudes from the surface 8aA in the direction Z1. FIG. 5 illustrates a configuration example in which an adhesive layer 2E is provided on the second main surface 2B of the cover member 2 to adhere the second main surface 2B to the side wall member 8b and the display panel 3.

The parameter T defined as described above is less than 0, preferably -0.1 or less, and more preferably -0.2 or less.

The present inventors have found that when an impact is applied to the corner 2D in a direction along the virtual line V (for example, in a head impact test or the like), a strong tensile stress is generated on the display side (the first main surface 2A side) at a position slightly inside the end surface 2C of the cover member 2. In response to this, the present inventors have found that by setting the parameter T within the above range, it is possible to prevent the tensile stress from becoming too high, and to suppress cracking of the cover member 2, even in such cases. That is, by designing the display device 1 such that the parameter T falls within the above range, cracking of the cover member 2 can be suppressed.

(Parameter T1)

A parameter T1 is set to a value represented by the following Formula (6).

$$T1 = 0.7416 - 0.01455 \times B - 0.01685 \times A + 0.000244 \times A \times B \tag{6}$$

The parameter T1 is preferably less than 0, more preferably -0.1 or less, and still more preferably -0.2 or less. By setting the parameter T1 within this range, cracking of the cover member 2 can be more suitably suppressed. That is, by increasing the parameter B, the cover member 2 can be appropriately protected by the side wall member, and the stress on the cover member 2 can be reduced, so that cracking of the cover member 2 can be more suitably suppressed.

Here, the parameter B is preferably greater than 0, more preferably 15 or more, still more preferably 50 or more, and even more preferably 70 or more. When the parameter B is within the above range, the rigidity of the side wall member can be increased, deformation of the cover member when an impact is applied to the corner 2D can be suppressed, and the generation of tensile stress can be suppressed.

(Parameter T2)

A parameter T2 is set to a value represented by the following Formula (7).

$$T2 = 0.313919 - 0.0045 \times C - 0.01057 \times A - 0.0000791 \times A \times C \ (7)$$

The parameter T2 is preferably less than 0, more preferably -0.1 or less, and still more preferably -0.2 or less. By setting the parameter T2 within this range, cracking of the cover member 2 can be more suitably suppressed. That is, by increasing the parameter C, the cover member 2 can be appropriately protected by the side wall member, and the stress on the cover member 2 can be reduced, so that cracking of the cover member 2 can be more suitably suppressed.

(Parameter T3)

A parameter T3 is set to a value represented by the following Formula (8).

$$T3 = 0.079709 + 0.001749 \times D - 0.00791 \times A - 0.000023 \times A \times D \ (8)$$

The parameter T3 is preferably less than 0, more preferably -0.1 or less, and still more preferably -0.2 or less. By setting the parameter T3 within this range, cracking of the cover member 2 can be more suitably reduced. That is, by lowering the parameter D, the impact can be appropriately absorbed by the bottom member 5 and the stress on the cover member 2 can be reduced, so that cracking of the cover member 2 can be more suitably suppressed.

(Parameter T4)

A parameter T4 is set to a value represented by the following Formula (9).

$$T4 = -0.40013 + 1.736071 \times G + 0.00185 \times A - 0.01998 \times G \times A \ (9)$$

The parameter T4 is preferably less than 0, more preferably -0.1 or less, and still more preferably -0.2 or less. By setting the parameter T4 within this range, cracking of the cover member 2 can be more suitably suppressed. That is, since the stress on the cover member 2 can be reduced by reducing the protrusion length of the cover member 2, cracking of the cover member 2 can be more suitably suppressed.

In the present embodiment, it is preferable that at least one of the parameters T1, T2, T3, and T4 is within the above range (for example, less than 0), it is more preferable that at least the parameter T1 is within the above range, and it is still more preferable that all of the parameters T1, T2, T3, and T4 are within the above range.

(Protrusion Length G)

For reasons of the design of the display device 1, the protrusion length G is preferably -0.7 mm or more and 3 mm or less, more preferably -0.55 mm or more and 2 mm or less, and still more preferably -0.55 mm or more and 1 mm or less. Even if the protrusion length G is relatively small as described above, cracking of the cover member 2 can be suppressed by setting the parameter T within the above range.

Further, when the protrusion length G is within the above range, the parameter T1 is more preferably 0.38 or less. Accordingly, even if the protrusion length G is relatively small as described above, cracking of the cover member 2 can be suitably suppressed.

(Effects)

As described above, the display device 1 according to a first aspect of the present disclosure includes a bottom member 5, a display panel 3 (display layer) provided on or above the bottom member 5, a side wall member provided around the display panel 3, and a glass cover member 2 provided on or above the display panel 3 and the side wall member and having a thickness tcg of 0.3 mm or more and 0.7 mm or less. When a direction from the bottom member 5 toward the cover member 2 in a thickness direction (Z direction) of the cover member 2 is defined as a first direction (direction Z1), the cover member 2 has a first main surface 2A on the first direction side, a second main surface 2B opposite to the first main surface 2A, and an end surface 2C connecting the first main surface 2A and the second main surface 2B, and a parameter T is less than 0.

According to the present disclosure, cracking of the cover member 2 having such a thickness can be suitably suppressed.

The display device 1 according to a second aspect of the present disclosure is the display device according to the first aspect, in which the cover member 2 preferably includes a strengthened glass having a compressive stress layer with a thickness of 10 $\mu$m or more, the Young's modulus Ecg of the cover member 2 is preferably 60 GPa or more and 90 GPa or less, and the Young's modulus Ed of the bottom member 5 is preferably 40 GPa or more and 250 GPa or less. According to the present disclosure, cracking of the cover member 2 can be suitably suppressed.

The display device 1 according to a third aspect of the present disclosure is the display device according to the first aspect or the second aspect, in which the protrusion length tc of the side wall member is preferably greater than 0 mm. According to the present disclosure, since a side wall portion including the portion protruding outward from the end surface 2C of the cover member 2 is provided, cracking of the cover member 2 can be suitably suppressed.

The display device 1 according to a fourth aspect of the present disclosure is the display device according to any one of the first to third aspects, in which the parameter B is preferably greater than 0. By setting the parameter B within this range, cracking of the cover member 2 can be suitably suppressed.

The display device 1 according to a fifth aspect of the present disclosure is the display device according to any one of the first to fourth aspects, in which the parameter T1 is preferably less than 0. By setting the parameter T1 within this range, cracking of the cover member 2 can be suitably suppressed.

The display device 1 according to a sixth aspect of the present disclosure is the display device according to any one of the first to fifth aspects, in which the protrusion length G of the first main surface 2A of the cover member 2 is preferably -0.7 mm or more and 3 mm or less. By setting the protrusion length G within this range, it is possible to suitably suppress cracking of the cover member 2 while making the design preferable.

The display device 1 according to a seventh aspect of the present disclosure is the display device according to any one of the first to sixth aspects, in which the thickness td of the bottom member 5 is preferably 0.5 mm or more and 5 mm or less. By setting the thickness of the bottom member 5 within this range, the housing 1A can be appropriately fixed while suitably suppressing cracking of the cover member 2.

The display device 1 according to an eighth aspect of the present disclosure is the display device according to any one of the first to seventh aspects, in which the parameter D is preferably 50 or more and 700 or less. By setting the parameter D within this range, cracking of the cover member 2 can be suitably reduced.

The display device 1 according to a ninth aspect of the present disclosure is the display device according to any one of the first to eighth aspects, in which the bottom member 5 includes a plate portion 6 and ribs 7 protruding from a main surface of the plate portion 6 on the direction Z2 side, at least two fixing points P to be fixed to a vehicle are formed on the main surface on the direction Z2 side, and when a virtual plane passing through an intermediate point of two fixing points P and perpendicular to a line connecting the two fixing points P is defined as a virtual plane R, a length of an intersection line between the main surface of the cover member 2 and the virtual plane R is defined as a distance $YH_{cg}$, and a length from an upper end to a point corresponding to the intermediate point in an intersection line between a main surface of the display panel 3 and the virtual plane R is defined as a distance YH, the ratio $YH/YH_{cg}$ of the distance YH to the distance $YH_{cg}$ is 0.5 or less. That is, the display device 1 is preferably an in-dash type. According to the present disclosure, cracking of the cover member 2 can be appropriately suppressed in the in-dash type display device 1.

The display device 1 according to a tenth aspect of the present disclosure is the display device according to any one of the first to ninth aspects, in which the parameter T is preferably -0.1 or less. By setting the parameter T within this range, cracking of the cover member 2 can be more suitably suppressed.

The display device 1 according to an eleventh aspect of the present disclosure is the display device according to any one of the first to tenth aspects, in which the parameter T is preferably -0.2 or less. By setting the parameter T within this range, cracking of the cover member 2 can be more suitably suppressed.

(Examples)

Next, Examples will be described. The embodiments may be modified as long as the effects of the invention are exhibited.

In Examples, a head impact test was simulated by generating a simulation model of the display device 1 and executing a simulation of applying an impact to the reference point H with respect to the simulation model of the display device 1. Hereinafter, the model of each Example will be described. Tables 1 to 4 are tables for describing each Example.

Table 1

| | | EX. 1 | EX. 2 | EX. 3 | EX. 4 | EX. 5 | EX. 6 | EX. 7 | EX. 8 | EX. 9 | EX. 10 | EX. 11 | EX. 12 | EX. 13 | EX. 14 |
|---|---|---|---|---|---|---|---|---|---|---|---|---|---|---|---|
| Cover member | Thickness tcg (mm) | 0.4 | 0.55 | 0.7 | 0.4 | 0.55 | 0.7 | 0.4 | 0.55 | 0.7 | 0.4 | 0.55 | 0.7 | 0.4 | 0.55 |
| | Young's modulus Ecg (GPa) | 74 | 74 | 74 | 74 | 74 | 74 | 74 | 74 | 74 | 74 | 74 | 74 | 74 | 74 |
| Side wall member 1 | Young's modulus Eb1 (GPa) | 2.5 | 2.5 | 2.5 | 2.5 | 2.5 | 2.5 | 2.5 | 2.5 | 2.5 | 2.5 | 2.5 | 2.5 | 2.5 | 2.5 |
| | Thickness tb1 (mm) | 2 | 2 | 2 | 2 | 2 | 2 | 2 | 2 | 2 | 2 | 2 | 2 | 2 | 2 |
| | Protrusion length tc1 (mm) | 2.35 | 2.35 | 2.35 | 2.35 | 2.35 | 2.35 | 2.35 | 2.35 | 2.35 | 2.35 | 2.35 | 2.35 | 2.35 | 2.35 |
| Side wall member 2 | Young's modulus Eb2 (GPa) | 0 | 0 | 0 | 70 | 70 | 70 | 70 | 70 | 70 | 70 | 70 | 70 | 70 | 70 |
| | Thickness tb2 (mm) | 0 | 0 | 0 | 0.5 | 0.5 | 0.5 | 1 | 1 | 1 | 1 | 1 | 1 | 1 | 1 |
| | Protrusion length tc2 (mm) | 0 | 0 | 0 | 2.35 | 2.35 | 2.35 | 2.35 | 2.35 | 2.35 | 0.85 | 0.85 | 0.85 | 1.35 | 1.35 |
| Bottom member | Young's modulus Ed (GPa) | 70 | 70 | 70 | 70 | 70 | 70 | 70 | 70 | 70 | 70 | 70 | 70 | 70 | 70 |
| | Thickness td (mm) | 2 | 2 | 2 | 2 | 2 | 2 | 2 | 2 | 2 | 2 | 2 | 2 | 2 | 2 |
| Cover member protrusion length G (mm) | | 0 | 0 | 0 | 0 | 0 | 0 | 0 | 0 | 0 | 0 | 0 | 0 | 0 | 0 |
| Parameter T | | 0.43 | 0.27 | 0.07 | 0.08 | 0.01 | -0.08 | -0.27 | -0.27 | -0.28 | -0.13 | -0.17 | -0.22 | -0.17 | -0.20 |
| Parameter T1 | | 0.43 | 0.27 | 0.07 | 0.22 | 0.11 | -0.03 | -0.39 | -0.36 | -0.33 | -0.39 | -0.36 | -0.33 | -0.39 | -0.36 |
| Parameter T2 | | 0.16 | 0.04 | -0.11 | -0.74 | -0.99 | -1.32 | -0.74 | -0.99 | -1.32 | -0.17 | -0.33 | -0.55 | -0.36 | -0.55 |
| Parameter T3 | | 0.40 | 0.25 | 0.05 | 0.40 | 0.25 | 0.05 | 0.40 | 0.25 | 0.05 | 0.40 | 0.25 | 0.05 | 0.40 | 0.25 |
| Parameter T4 | | -0.38 | -0.36 | -0.33 | -0.38 | -0.36 | -0.33 | -0.38 | -0.36 | -0.33 | -0.38 | -0.36 | -0.33 | -0.38 | -0.36 |
| Determination | | C | C | C | C | C | B | A | A | A | A | A | A | A | A |

EP 4 756 785 A1

16

Table 2

| | | EX. 15 | EX. 16 | EX. 17 | EX. 18 | EX. 19 | EX. 20 | EX. 21 | EX. 22 | EX. 23 | EX. 24 | EX. 25 | EX. 26 | EX. 27 |
|---|---|---|---|---|---|---|---|---|---|---|---|---|---|---|
| Cover member | Thickness tcg (mm) | 0.7 | 0.4 | 0.55 | 0.7 | 0.4 | 0.55 | 0.7 | 0.4 | 0.55 | 0.7 | 0.4 | 0.55 | 0.7 |
| | Young's modulus Ecg (GPa) | 74 | 74 | 74 | 74 | 74 | 74 | 74 | 74 | 74 | 74 | 74 | 74 | 74 |
| Side wall member 1 | Young's modulus Eb1 (GPa) | 2.5 | 2.5 | 2.5 | 2.5 | 2.5 | 2.5 | 2.5 | 2.5 | 2.5 | 2.5 | 2.5 | 2.5 | 2.5 |
| | Thickness tb1 (mm) | 2 | 2 | 2 | 2 | 2 | 2 | 2 | 2 | 2 | 2 | 2 | 2 | 2 |
| | Protrusion length tc1 (mm) | 2.35 | 2.35 | 2.35 | 2.35 | 2.35 | 2.35 | 2.35 | 2.35 | 2.35 | 2.35 | 2.35 | 2.35 | 2.35 |
| Side wall member 2 | Young's modulus Eb2 (GPa) | 70 | 0 | 0 | 0 | 0 | 0 | 0 | 70 | 70 | 70 | 70 | 70 | 70 |
| | Thickness tb2 (mm) | 1 | 0 | 0 | 0 | 0 | 0 | 0 | 1 | 1 | 1 | 1 | 1 | 1 |
| | Protrusion length tc2 (mm) | 1.35 | 0 | 0 | 0 | 0 | 0 | 0 | 2.35 | 2.35 | 2.35 | 2.35 | 2.35 | 2.35 |
| Bottom member | Young's modulus Ed (GPa) | 70 | 70 | 70 | 70 | 70 | 70 | 70 | 70 | 70 | 70 | 70 | 70 | 70 |
| | Thickness td (mm) | 2 | 1 | 1 | 1 | 3 | 3 | 3 | 2 | 2 | 2 | 2 | 2 | 2 |
| Cover member protrusion length G (mm) | | 0 | 0 | 0 | 0 | 0 | 0 | 0 | 0.1 | 0.1 | 0.1 | 0.2 | 0.2 | 0.2 |
| Parameter T | | -0.24 | 0.12 | 0.01 | -0.13 | 0.94 | 0.70 | 0.39 | -0.19 | -0.20 | -0.21 | -0.10 | -0.12 | -0.14 |
| Parameter T1 | | -0.33 | 0.43 | 0.27 | 0.07 | 0.43 | 0.27 | 0.07 | -0.39 | -0.36 | -0.33 | -0.39 | -0.36 | -0.33 |
| Parameter T2 | | -0.81 | 0.16 | 0.04 | -0.11 | 0.16 | 0.04 | -0.11 | -0.74 | -0.99 | -1.32 | -0.74 | -0.99 | -1.32 |
| Parameter T3 | | 0.05 | 0.09 | -0.01 | -0.14 | 0.92 | 0.68 | 0.37 | 0.40 | 0.25 | 0.05 | 0.40 | 0.25 | 0.05 |
| Parameter T4 | | -0.33 | -0.38 | -0.36 | -0.33 | -0.38 | -0.36 | -0.33 | -0.23 | -0.23 | -0.23 | -0.08 | -0.10 | -0.13 |
| Determination | | A | C | C | A | C | C | C | A | A | A | B | A | A |

Table 3

| | | EX. 28 | EX. 29 | EX. 30 | EX. 31 | EX. 32 | EX. 33 | EX. 34 | EX. 35 | EX. 36 | EX. 37 | EX. 38 | EX. 39 |
|---|---|---|---|---|---|---|---|---|---|---|---|---|---|
| Cover member | Thickness tcg (mm) | 0.4 | 0.55 | 0.7 | 0.4 | 0.55 | 0.7 | 0.4 | 0.55 | 0.7 | 0.4 | 0.55 | 0.7 |
| | Young's modulus Ecg (GPa) | 74 | 60 | 60 | 60 | 60 | 60 | 74 | 74 | 74 | 74 | 74 | 74 |
| Side wall member 1 | Young's modulus Eb1 (GPa) | 2.5 | 2.5 | 2.5 | 2.5 | 2.5 | 2.5 | 2.5 | 2.5 | 2.5 | 2.5 | 2.5 | 2.5 |
| | Thickness tb1 (mm) | 2 | 2 | 2 | 2 | 2 | 2 | 1 | 1 | 1 | 1 | 1 | 2 |
| | Protrusion length tc1 (mm) | 2.35 | 2.35 | 2.35 | 2.35 | 2.35 | 2.35 | 2.35 | 2.35 | 2.35 | 2.35 | 2.35 | 2.35 |
| Side wall member 2 | Young's modulus Eb2 (GPa) | 70 | 70 | 70 | 70 | 70 | 70 | 70 | 70 | 70 | 70 | 70 | 70 |
| | Thickness tb2 (mm) | 1 | 1 | 1 | 1 | 1 | 1 | 1 | 1 | 1 | 1 | 1 | 1 |
| | Protrusion length tc2 (mm) | 2.35 | 2.35 | 2.35 | 2.35 | 2.35 | 2.35 | 2.35 | 2.35 | 2.35 | 2.35 | 2.35 | 2.35 |
| Bottom member | Young's modulus Ed (GPa) | 70 | 70 | 70 | 70 | 70 | 70 | 70 | 70 | 70 | 70 | 70 | 70 |
| | Thickness td (mm) | 2 | 2 | 2 | 2 | 2 | 2 | 2 | 2 | 2 | 2 | 2 | 2 |
| Cover member protrusion length G (mm) | | 0.1 | 0.1 | 0.1 | 0.2 | 0.2 | 0.2 | 0.1 | 0.1 | 0.1 | 0.2 | 0.2 | 0.2 |
| Parameter T | | -0.19 | -0.19 | -0.20 | -0.10 | -0.11 | -0.13 | -0.14 | -0.15 | -0.18 | -0.05 | -0.08 | -0.14 |
| Parameter T1 | | -0.39 | -0.37 | -0.34 | -0.40 | -0.37 | -0.34 | -0.30 | -0.29 | -0.28 | -0.30 | -0.29 | -0.33 |
| Parameter T2 | | -0.74 | -0.89 | -1.16 | -0.68 | -0.89 | -1.16 | -0.74 | -0.99 | -1.32 | -0.74 | -0.99 | -1.32 |
| Parameter T3 | | 0.40 | 0.31 | 0.15 | 0.43 | 0.31 | 0.15 | 0.40 | 0.25 | 0.05 | 0.40 | 0.25 | 0.05 |
| Parameter T4 | | -0.23 | -0.23 | -0.23 | -0.07 | -0.09 | -0.12 | -0.23 | -0.23 | -0.23 | -0.08 | -0.10 | -0.13 |
| Determination | | A | A | A | B | A | A | A | A | A | B | B | A |

Table 4

| | | EX. 40 | EX. 41 | EX. 42 | EX. 43 | EX. 44 | EX. 45 | EX. 46 | EX. 47 | EX. 48 | EX. 49 | EX. 50 | EX. 51 |
|---|---|---|---|---|---|---|---|---|---|---|---|---|---|
| Cover member | Thickness tcg (mm) | 0.4 | 0.55 | 0.7 | 0.4 | 0.55 | 0.7 | 0.4 | 0.55 | 0.7 | 0.4 | 0.55 | 0.7 |
| | Young's modulus Ecg (GPa) | 74 | 74 | 74 | 74 | 74 | 74 | 74 | 74 | 74 | 74 | 74 | 74 |
| Side wall member 1 | Young's modulus Eb1 (GPa) | 2.5 | 2.5 | 2.5 | 2.5 | 2.5 | 2.5 | 2.5 | 2.5 | 2.5 | 2.5 | 2.5 | 2.5 |
| | Thickness tb1 (mm) | 2 | 2 | 2 | 2 | 2 | 2 | 2 | 2 | 2 | 2 | 2 | 2 |
| | Protrusion length tcd1 (mm) | 1 | 1 | 1 | 1 | 1 | 1 | 2.35 | 2.35 | 2.35 | 2.35 | 2.35 | 2.35 |
| Side wall member 2 | Young's modulus Eb2 (GPa) | 70 | 70 | 70 | 70 | 70 | 70 | 70 | 70 | 70 | 70 | 70 | 70 |
| | Thickness tb2 (mm) | 1 | 1 | 1 | 1 | 1 | 1 | 1 | 1 | 1 | 1 | 1 | 1 |
| | Protrusion length tc2 (mm) | 2.35 | 2.35 | 2.35 | 2.35 | 2.35 | 2.35 | 2.35 | 2.35 | 2.35 | 2.35 | 2.35 | 2.35 |
| Bottom member | Young's modulus Ed (GPa) | 70 | 70 | 70 | 70 | 70 | 70 | 200 | 200 | 200 | 200 | 200 | 200 |
| | Thickness td (mm) | 2 | 2 | 2 | 2 | 2 | 2 | 2 | 2 | 2 | 2 | 2 | 2 |
| Cover member protrusion length G (mm) | | 0.1 | 0.1 | 0.1 | 0.2 | 0.2 | 0.2 | 0.1 | 0.1 | 0.1 | 0.2 | 0.2 | 0.2 |
| Parameter T | | -0.18 | -0.19 | -0.20 | -0.09 | -0.11 | -0.14 | 0.57 | 0.45 | 0.27 | 0.66 | 0.52 | 0.34 |
| Parameter T1 | | -0.39 | -0.36 | -0.33 | -0.39 | -0.36 | -0.33 | -0.39 | -0.36 | -0.33 | -0.39 | -0.36 | -0.33 |
| Parameter T2 | | -0.72 | -0.97 | -1.30 | -0.72 | -0.97 | -1.30 | -0.74 | -0.99 | -1.32 | -0.74 | -0.99 | -1.32 |
| Parameter T3 | | 0.40 | 0.25 | 0.05 | 0.40 | 0.25 | 0.05 | 1.17 | 0.89 | 0.52 | 1.17 | 0.89 | 0.52 |
| Parameter T4 | | -0.23 | -0.23 | -0.23 | -0.08 | -0.10 | -0.13 | -0.23 | -0.23 | -0.23 | -0.08 | -0.10 | -0.13 |
| Determination | | A | A | A | B | A | A | C | C | C | C | C | C |

(Example 1)

In Example 1, a model of a display device including a cover member, the display panel 3, a side wall member, and a bottom member was prepared. That is, the model of the display device 1 employed the structure described in FIG. 2 and FIG. 5.

In the model of the display device 1 of Example 1, the size of the cover member was 250 mm in the X direction, 150 mm in the Y direction, and 0.4 mm in the Z direction (thickness tcg was 0.4 mm), the thickness of the compressive stress layer was 20 μm, and the Young's modulus Ecg was 74 GPa.

In the model of the display device 1, the size of the display panel 3 was set to 170 mm in the X direction and 125 mm in the Y direction, and the thickness in the Z direction was set to 1.1 mm.

The distance S1 between an end portion of the cover member in the Y direction and an end portion of the display panel 3 in the Y direction was set to 12.5 mm, and the distance S2 between an end portion of the cover member in the X direction and an end portion of the display panel 3 in the X direction was set to 40 mm.

For the side wall member (side wall member 1 in Table 1), the thickness tb1 was set to 2 mm, the protrusion length tc1 outward from an end surface of the cover member was set to 2.35 mm, and the Young's modulus Eb1 was set to 2.5 GPa.

The bottom member was set to have the same sizes in the X and Y directions as the cover member, the thickness td was set to 2 mm, and the Young's modulus Ed was set to 70 GPa.

A frame member surrounding the cover member was also provided so as to be integrated with the side wall member (side wall member 1 in Table 1). The protrusion length G of the first main surface of the cover member on the direction Z1 side from a surface of the frame member on the direction Z1 side to the direction Z1 side was set to 0 mm. That is, the surface of the frame member on the direction Z1 side and the first main surface of the cover member on the direction Z1 side are flush with each other.

In the model of the display device, a bracket was disposed on a surface of the bottom member on the direction Z2 side with fixing points P set such that the ratio $YH/YH_{cg}$ was 0.5. The position of each fixing point in the X direction was set to a center position between the end portion of the cover member in the X direction and the end portion of the display panel in the X direction.

The reference point H was set at a position on a corner of the cover member on the direction Y1 side where distances from fixing points P1 and P2 were equal.

As shown in Table 1, the parameters T, T1, T2, T3, and T4 were calculated using Formula (5) to Formula (9).

(Examples 2 to 51)

In Examples 2 to 51, as shown in Tables 1 to 4, models were generated by changing at least one of the thickness tcg and the Young's modulus Ecg of the cover member, the thickness tb1 and the protrusion length tc1 of the side wall member, the presence or absence of a second side wall member (side wall member 2 in Table 1), the thickness td, the Young's modulus Ed, and the protrusion length G of the bottom member, as compared with Example 1. The thickness of the compressive stress layer was set to 20 μm. The second side wall member (side wall member 2 in Table 1) is a side wall member on the direction Z2 side of the first side wall member (side wall member 1 in Table 1). That is, the first side wall member (side wall member 1 in Table 1) corresponds to the side wall member 8b illustrated in FIG. 5, and the second side wall member (side wall member 2 in Table 1) corresponds to the side wall member 8c illustrated in FIG. 5.

(Evaluation)

A simulation was executed in which an impactor was caused to collide with the reference point H of the model generated in each Example under the following conditions.

·Impactor collision energy: 97 (J)
·Impactor weight: 6.8 (kg)
·Impactor diameter: 165 (mm)
·Impactor collision angle (inclination angle of collision direction of impactor with respect to Z direction): 55°

(Evaluation Results)

Analysis results of the stress generated in a glass article when the impactor collides with the reference point H were acquired by the simulation. A case where the maximum stress generated in the glass article was 95% or less with respect to a threshold of cracking generation was defined as A, a case where the maximum stress was greater than 95% and less than 100% was defined as B, and a case where the maximum stress was 100% or more was defined as C. A and B were regarded as pass, and C was regarded as fail.

As shown in Tables 1 to 4, in Examples 6 to 15, 18, and 22 to 45, which are examples in which the parameter T was less than 0, the evaluation results were pass, and it is clear that cracking can be suppressed. On the other hand, in Examples 1 to 5, 16 and 17, 19 to 21, and 46 to 51, which are comparative examples in which the parameter T was 0 or more, the evaluation results were fail, and it is clear that cracking cannot be suppressed.

Although the embodiments of the present invention have been described above, the embodiments are not limited to the contents of these embodiments. In addition, the components described above should include those that can be easily conceived by those skilled in the art, those that are substantially the same, and those within a so-called equivalent range. Further, the above components can be appropriately combined. Further, various omissions, substitutions, or modifications of the components can be made without departing from the gist of the embodiments described above.

INDUSTRIAL APPLICABILITY

According to the present invention, it is possible to provide a display device capable of suppressing cracking of a cover member.

Although the present invention has been described in detail with reference to specific embodiments, it is apparent to those skilled in the art that various changes and modifications can be made without departing from the spirit and scope of the present invention.

The present application is based on a Japanese Patent Application (Japanese Patent Application No. 2023-123718) filed on July 28, 2023, the contents of which are incorporated herein by reference.

REFERENCE SIGNS LIST

1 display device
1A housing
2 cover member
2A first main surface
2B second main surface
2C end surface
3 display panel
4 backlight unit
5 bottom member
6 plate portion
7 rib
8 surrounding member
8a frame member
8b, 8c side wall member
9 bracket
10 interior portion

**Claims**

1. A display device comprising:

    a bottom member;
    a display layer provided on or above the bottom member;
    a side wall member provided around the display layer; and
    a cover member comprising a glass, provided on or above the display layer and the side wall member, and having a thickness of 0.3 mm or more and 0.7 mm or less, wherein
    when a direction from the bottom member toward the cover member in a thickness direction of the cover member is defined as a first direction, the cover member has a first main surface on a first direction side, a second main surface opposite to the first main surface, and an end surface connecting the first main surface and the second main surface, and
    a parameter T is less than 0,
    provided that a parameter A, a parameter B, a parameter C, a parameter D, and the parameter T are represented by the following Formula (1) to Formula (5):

$$A = Ecg \times tcg^2 \qquad (1)$$

$$B = \Sigma(Eb \times tb^2) \qquad (2)$$

$$C = \Sigma(Eb \times tc) \qquad (3)$$

$$D = Ed \times td^2 \qquad (4)$$

T = 0.212245 + A(-0.00997 + 0.000124 $\times$ B + 0.0000362 $\times$ C - 0.000022 $\times$ D - 0.00809 $\times$ G) - 0.00817 $\times$ B - 0.00183 $\times$ C + 0.001722 $\times$ D + 0.957752 $\times$ G $\qquad$ (5)

where Ecg is a Young's modulus (GPa) of the cover member,
tcg is the thickness (mm) of the cover member,
Eb is a Young's modulus (GPa) of the side wall member,
tb is a thickness (mm) of a portion of the side wall member protruding outward from the end surface of the cover member,
tc is a protrusion length (mm) of the portion of the side wall member protruding outward from the end surface of the cover member,
Ed is a Young's modulus (GPa) of the bottom member,
td is a thickness (mm) of the bottom member, and
G is a protrusion length (mm) of the first main surface of the cover member in the first direction from a surface of a frame member on the first direction side, the frame member being adjacent to an outer side of the end surface of the cover member.

2. The display device according to claim 1, wherein

the cover member comprises a strengthened glass having a compressive stress layer with a thickness of 10 $\mu$m or more,
the Young's modulus Ecg of the cover member is 60 GPa or more and 90 GPa or less, and
the Young's modulus Ed of the bottom member is 40 GPa or more and 250 GPa or less.

3. The display device according to claim 1 or 2, wherein
the protrusion length tc of the side wall member is greater than 0 mm.

4. The display device according to claim 1 or 2, wherein
the parameter B is greater than 0.

5. The display device according to claim 1 or 2, wherein
a parameter T1 represented by the following Formula (6) is less than 0,

$$T1 = 0.7416 - 0.01455 \times B - 0.01685 \times A + 0.000244 \times A \times B \qquad (6).$$

6. The display device according to claim 1 or 2, wherein
the protrusion length G of the first main surface of the cover member is -0.7 mm or more and 3 mm or less.

7. The display device according to claim 1 or 2, wherein
the thickness td of the bottom member is 0.5 mm or more and 5 mm or less.

8. The display device according to claim 1 or 2, wherein
the parameter D is 50 or more and 700 or less.

9. The display device according to claim 1 or 2, wherein

the bottom member includes a plate portion and a rib protruding from a main surface of the plate portion on the side opposite to the first direction,

at least two fixing points to be fixed to a vehicle are formed on the main surface on the side opposite to the first direction, and

when a virtual plane passing through an intermediate point of the two fixing points and perpendicular to a line connecting the two fixing points is defined as a virtual plane R, a length of an intersection line between the main surface of the cover member and the virtual plane R is defined as a distance $YH_{cg}$, and a length from an upper end to a point corresponding to the intermediate point in an intersection line between a main surface of the display layer and the virtual plane R is defined as a distance YH, a ratio $YH/YH_{cg}$ of the distance YH to the distance $YH_{cg}$ is 0.5 or less.

10. The display device according to claim 1 or 2, wherein
the parameter T is -0.1 or less.

11. The display device according to claim 1 or 2, wherein
the parameter T is -0.2 or less.

*FIG. 1*

FIG. 2

# FIG. 3

FIG. 4

EP 4 756 785 A1

FIG. 5

FIG. 6

## INTERNATIONAL SEARCH REPORT

International application No.

**PCT/JP2024/026361**

**A.    CLASSIFICATION OF SUBJECT MATTER**

*G09F 9/00*(2006.01)i; *B60K 35/00*(2024.01)i; *C03C 21/00*(2006.01)i
FI:    G09F9/00 313; G09F9/00 302; B60K35/00; C03C21/00 101

According to International Patent Classification (IPC) or to both national classification and IPC

**B.    FIELDS SEARCHED**

Minimum documentation searched (classification system followed by classification symbols)

G09F9/00; B60K35/00; C03C21/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2018/194103 A1 (AGC INC.) 25 October 2018 (2018-10-25)<br>entire text, all drawings | 1-11 |
| A | JP 2019-19054 A (AGC INC.) 07 February 2019 (2019-02-07)<br>entire text, all drawings | 1-11 |
| A | WO 2015/093269 A1 (KYOCERA CORPORATION) 25 June 2015 (2015-06-25)<br>entire text, all drawings | 1-11 |

☐ Further documents are listed in the continuation of Box C.      ☑ See patent family annex.

| | |
|---|---|
| *    Special categories of cited documents:<br>"A"    document defining the general state of the art which is not considered to be of particular relevance<br>"D"    document cited by the applicant in the international application<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **15 August 2024** | **03 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

| | International application No. |
|---|---|
| | **PCT/JP2024/026361** |

| Patent document cited in search report | | | Publication date (day/month/year) | Patent family member(s) | | | Publication date (day/month/year) |
|---|---|---|---|---|---|---|---|
| WO | 2018/194103 | A1 | 25 October 2018 | US | 2020/0051466 | A1 | |
| | | | | DE | 112018002116 | T | |
| | | | | CN | 110574095 | A | |
| JP | 2019-19054 | A | 07 February 2019 | WO | 2016/027812 | A1 | |
| | | | | DE | 112015003842 | T | |
| | | | | TW | 201613831 | A | |
| | | | | CN | 106604902 | A | |
| | | | | KR | 10-2017-0048249 | A | |
| | | | | CN | 110264874 | A | |
| | | | | TW | 202003399 | A | |
| WO | 2015/093269 | A1 | 25 June 2015 | US | 2015/0177790 | A1 | |
| | | | | US | 9001996 | B1 | |
| | | | | EP | 3086306 | A1 | |
| | | | | CN | 105874522 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016027812 A

- JP 2023123718 A

**Non-patent literature cited in the description**

- *JIS K7161-1, 2*, 2014
- *JIS K7113*, 1995

- *JIS D 1601*, 1995